# EUROPEAN PATENT APPLICATION

(11) **EP 3 312 975 A1**
(43) Date of publication of application: **25.04.2018**
(21) Application number: 17195194.0
(22) Date of filing: 06.10.2017
(51) Int. Cl.: H02K 11/33, H02K 5/22, B66D 1/12, H05K 5/06, H05K 7/14

(54) **MOTOR CONTROL MODULES WITH MULTIPLE POTTED SUB-MODULES, AND ASSOCIATED SYSTEMS AND METHODS**

(30) Priority: 06.10.2016 US 201662405146 P; 04.10.2017 US 201715724652
(71) Applicant: Superwinch, LLC, Dayville, CT 06241 (US)
(72) Inventor: AUGUST, Jacob, Sherwood, Oregon 97140 (US); DENNIS, Ron, Woodburn, Oregon 97071 (US); FRAZIER, Timothy, Beaverton, Oregon 97007 (US); MASON, Jon, Old Saybrook, Connecticut 06475 (US); SALMON, Scott, Dayville, Connecticut 06241 (US); HARGRODER, Ty, Los Angeles, California 90069 (US); SCUITO, David, Molalla, Oregon 97038 (US); BURNS, David, Wilsonville, Oregon 97070 (US); NASSET, Brent, Salem, Oregon 97305 (US)
(74) Representative: Hoarton, Lloyd Douglas Charles

(57) **Abstract**

Motor control modules with multiple potted sub-modules, and associated systems and methods are disclosed. A representative electric motor control module can include a potted contactor module, a potted controller module at least partially nested inside the contactor module and mechanically connected to the contactor module, and one or more connectors positioned between and electrically connecting the contactor module and the controller module.

## Description

### CROSS-REFERENCE TO RELATED APPLICATION

This application claims the benefit of and priority to U.S. Patent Application No. 62/405,146, filed October 6, 2016, the disclosure of which is incorporated herein by reference in its entirety.

### TECHNICAL FIELD

The present technology is directed to winches and, more specifically, to electric motor control modules for winches, and associated systems and methods.

### BACKGROUND

Potting is a process that generally includes encasing electronics, typically within a housing, with a liquid epoxy or other plastic material that hardens into a solid in order to protect the electronics from moisture and other contaminants. While potting protects electronics, it makes it difficult, if not impossible, to repair faulty electronics. Therefore, if a single component in an electronic assembly fails, the entire electronic assembly must be replaced.

### BRIEF DESCRIPTION OF THE DRAWINGS

Embodiments of representative motor control modules with multiple potted sub-modules described herein may be better understood by referring to the following Detailed Description in conjunction with the accompanying drawings, in which like reference numerals indicate identical or functionally similar elements:
FIG. 1 is an isometric view of a winch with a potted winch control module configured in accordance with some embodiments of the present technology;
FIG. 2 is an isometric view of the control module shown in FIG. 1;
FIG. 3 is an isometric view illustrating a separately potted contactor module and wireless controller module configured in accordance with some embodiments of the present technology;
FIG. 4 is an isometric view of the control module shown in FIG. 2 with the housing removed to illustrate the control module electronics within;
FIG. 5 is a top plan view of a representative control module with the cover removed to illustrate a connector cavity between the contactor module and wireless controller module;
FIG. 6 is an isometric view of the contactor module positioned for potting according to some embodiments;
FIG. 7 is an isometric view of the wireless controller module positioned for potting according to some embodiments;
FIG. 8 is a partially exploded isometric view of the wireless controller module positioned for potting according to some embodiments.

The headings provided herein are for convenience only and do not necessarily affect the scope of the embodiments. Further, the drawings have not necessarily been drawn to scale. For example, the dimensions of some of the elements in the Figures may be expanded or reduced to help improve the understanding of the embodiments. Moreover, while the disclosed technology is amenable to various modifications and alternative forms, specific embodiments have been shown by way of example in the drawings and are described in detail below. The intention, however, is not to unnecessarily limit the embodiments described. On the contrary, the embodiments are intended to cover all suitable modifications, combinations, equivalents, and/or alternatives falling within the scope of this disclosure.

### DETAILED DESCRIPTION

### Overview

A motor control module with multiple potted sub-modules is disclosed. The control module can include a contactor module and a wireless controller module. The contactor module and the wireless controller module can be separate modules that are joined together. Each module can be separately potted so that if a component failure occurs, only the affected module, rather than the entire control module, need be replaced. The contactor module and the wireless controller module can be electrically connected with suitable connectors, such as military style connectors, that provide a reliable weatherproof connection between the modules.

### General Description

Various examples of the devices introduced above will now be described in further detail. The following description provides specific details for a thorough understanding and enabling description of these examples. One skilled in the relevant art will understand, however, that the techniques and technology discussed herein may be practiced without many of these details. Likewise, one skilled in the relevant art will also understand that the technology can include many other features not described in detail herein. Additionally, some well-known structures or functions may not be shown or described in detail below so as to avoid unnecessarily obscuring the relevant description.

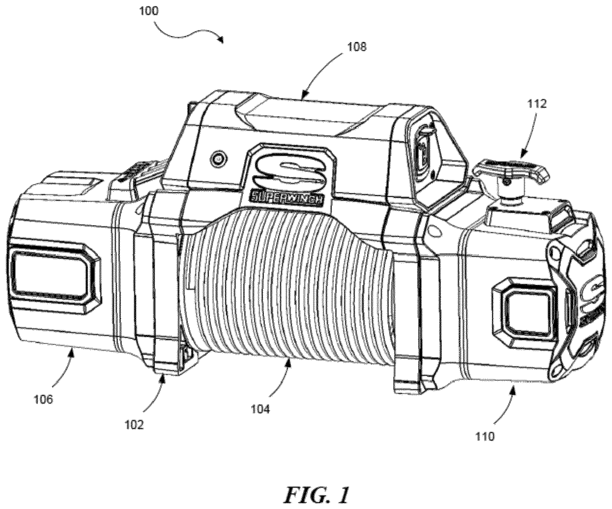

FIG. 1 illustrates a winch 100 including a motor control module 108 with multiple potted sub-modules in accordance with some representative embodiments. The winch 100 can include a frame assembly 102 that supports a drive motor 106 which powers a cable drum 104. The drive motor 106 drives the drum 104 through a gear train assembly 110. A clutch mechanism 112 engages and disengages the drum 104 from the gear train assembly 110 to facilitate quickly and easily unwinding the cable from the drum 104. A control pack or module 108 can span across the cable drum 104 and houses control circuitry for the winch 100.

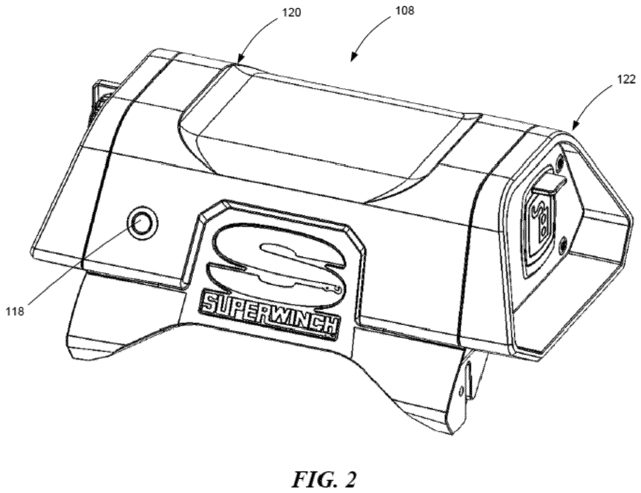

As shown in FIG. 2, the control module 108 can include a contactor module 120 and a wireless controller module 122. Accordingly, the contactor module 120 and the wireless controller module 122 can function as sub-modules of the overall, higher level control module 108.

The contactor module 120 can include a switch that directs vehicle battery current to the drive motor 106. The contactor module 120 can receive signals on low amperage coils from the wireless controller module 122 to switch vehicle battery current to flow in one of two directions (e.g., forward and reverse) to the drive motor 106. The wireless controller module 122 can perform several functions. For example, the wireless controller module 122 can receive a signal from a paired secured transmitter to direct the direction of the drive motor 106. In some embodiments, the wireless controller module 122 can be configured to only operate the winch 100 if a remote control (not shown) has been properly activated through a startup and syncing feature and has been previously paired with the wireless controller module 122.

In some embodiments, the wireless controller module 122 can also include one or more sensors (e.g., a Hall effect sensor) that determine a current draw of the winch 100, which is processed by the wireless controller module 122 to display a status of the winch via an indicator assembly 118 including an indicator light, such as a tricolor light emitting diode (LED). Each color displayed by the indicator assembly 118 can correspond to a pre-programmed current value, for example. In some embodiments, the wireless controller module 122 can also monitor other inputs such as winch speed, battery voltage level, and/or motor temperature.

The contactor module 120 and the wireless controller module 122 can be initially separate and then joined together. Each module can be separately potted so that if a component failure occurs, only the affected module (e.g., the contactor module 120 or the wireless controller module 122) need be replaced, as opposed to replacing the entire control module 108 of which the contactor module 120 and the wireless controller module 122 are constituents. The contactor module 120 and the wireless controller module 122 can each represent approximately half of the cost of the entire control module 108. In some embodiments, the cost ratio is approximately 60:40, respectively. Accordingly, the process of replacing components is more cost effective, in that a user can replace only the damaged module instead of the entire module, which would cost roughly twice as much. If improvements are made to the design of the contactor module 120 or the wireless controller module 122, a user can add the upgraded module much more inexpensively than having to replace the entire control module 108.

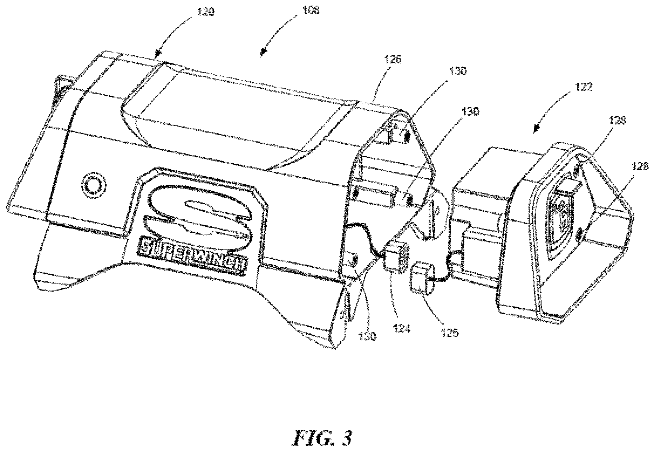

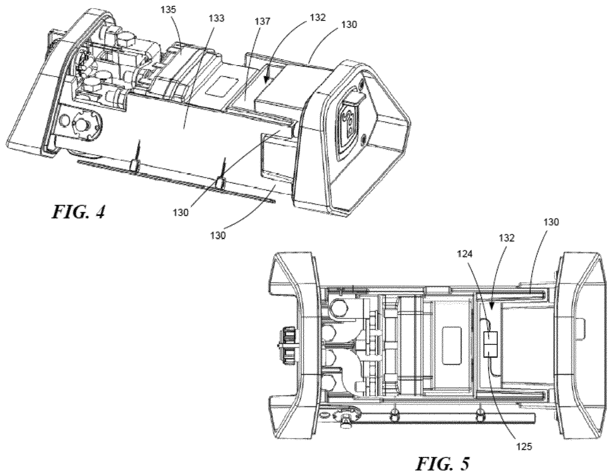

With reference to FIG. 3, the contactor module 120 and the wireless controller module 122 can be electrically connected via suitable connectors 124 and 125. In some embodiments, the connectors 124 and 125 can be military style connectors which form a weatherproof connection. In some embodiments, the wireless controller module 122 can partially nest within the housing 126 of the contactor module 120. The wireless controller module 122 can be mechanically connected or secured to the contactor module 120 with fasteners 128 (which thread into standoffs 130) and/or via other suitable arrangements, such as latches or snap together features, for example. With further reference to FIG. 4, the standoffs 130 can form part of a carrier tray 133 that houses a contactor 135 and other components of the contactor module 120. The standoffs 130 position the wireless controller module 122 away from an end wall 137 of the carrier tray 133 to create a connector cavity 132 configured to accommodate the connectors 124 and 125 between the carrier tray 133 and wireless controller module 122 when the modules are assembled together (see FIG. 5).

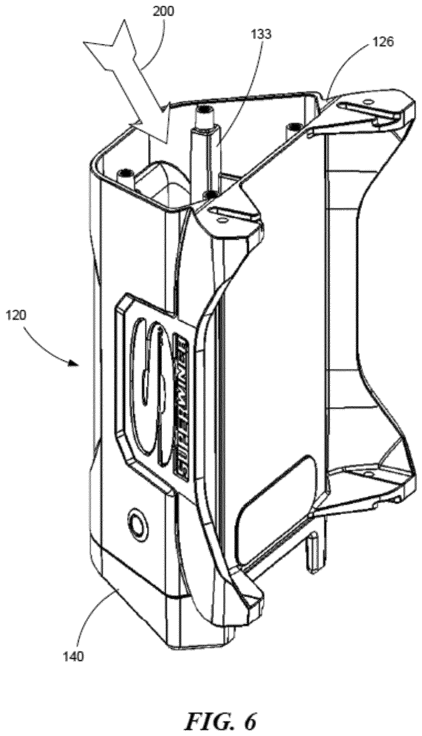

As shown in FIG. 6, the contactor module 120 can be potted by assembling the contactor 135 (FIG. 4), carrier tray 133, end cap 140, and contactor housing 126 together and pouring or otherwise disposing potting material (represented schematically by arrow 200) into the housing 126. In some embodiments, the housing 126 is filled with potting material up to the end wall 137 of the connector cavity 132 (FIG. 4). By potting the contactor module 120 after its components are installed into the housing 126, the electrical contacts as well as the openings for various connectors and lights, such as indicator assembly 118 (FIG. 2), can be completely sealed to protect the module from the environment.

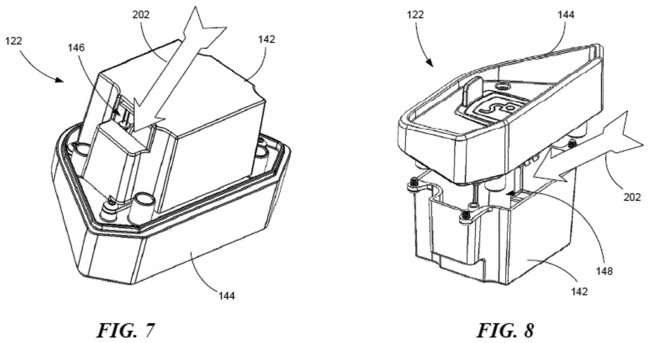

FIGS. 7 and 8 illustrate two different embodiments for potting the wireless controller module 122. The wireless controller module 122 can include a control housing 142, end cap 144, and electrical components contained in the control housing 142. In FIG. 7, the wireless controller module 122 can be potted through an aperture 146 formed in the wireless controller module housing 142. The potting material (represented schematically by arrow 202) is poured or otherwise disposed into the aperture 146 and contained in the volume created between the housing 142 and the end cap 144. In some embodiments, the wireless controller module 122 can be filled with potting material up to the edge of the aperture 146.

In some embodiments, such as that shown in FIG. 8, the wireless controller module 122 can be potted before assembling the end cap 144 onto the housing 142. The potting material (represented schematically by arrow 202) can be poured into the opening 148 at the top of the housing 142 prior to assembly. In some embodiments, the housing 142 can be filled to the edge of the opening 148 with the potting material.

One feature of a motor control module with multiple potted sub-modules in accordance with embodiments described above, is that the modules can be replaced independently of each other. An advantage of this arrangement is that the modules can achieve military grade sealing (via potting), but the individual, separable modules can reduce the costs for component replacement. Accordingly, while the cost of the components in a single potted sub-module may be significant, it is also significantly less than the cost of the components in the entire controller module.

The above description, drawings, and appendices are illustrative and are not to be construed as limiting. Numerous specific details are described to provide a thorough understanding of the disclosure. However, in some instances, well-known details are not described in order to avoid obscuring the description. Further, various modifications may be made without deviating from the scope of the embodiments.

Reference in this specification to "one embodiment" or "an embodiment" means that a particular feature, structure, or characteristic described in connection with the embodiment is included in at least one embodiment of the disclosure. The appearances of the phrase "in one embodiment" in various places in the specification are not necessarily all referring to the same embodiment, nor are separate or alternative embodiments mutually exclusive of other embodiments. Moreover, various features are described which may be exhibited by some embodiments and not by others. Similarly, various requirements are described which may be requirements for some embodiments but not for other embodiments.

The terms used in this specification generally have their ordinary meanings in the art, within the context of the disclosure, and in the specific context where each term is used. It will be appreciated that the same thing can be said in more than one way. Consequently, alternative language and synonyms may be used for any one or more of the terms discussed herein, and any special significance is not to be placed upon whether or not a term is elaborated or discussed herein. Synonyms for some terms are provided. A recital of one or more synonyms does not exclude the use of other synonyms. The use of examples anywhere in this specification, including examples of any term discussed herein, is illustrative only and is not intended to further limit the scope and meaning of the disclosure or of any exemplified term. Likewise, the disclosure is not limited to various embodiments given in this specification. Unless otherwise defined, all technical and scientific terms used herein have the same meaning as commonly understood by one of ordinary skill in the art to which this disclosure pertains. In the case of conflict, the present document, including definitions, will control.

In some embodiments, a representative control module comprises a first potted sub-module and a second potted sub-module electrically and mechanically connected together.

In some embodiments, a representative electric motor control module comprises a potted contactor module and a potted wireless controller module attached to the contactor module. In some embodiments, the wireless controller module is at least partially nested inside the contactor module. In some embodiments, the contactor module and the wireless controller module are electrically interconnected with connectors positioned between the contactor module and the wireless controller module.

In some embodiments, a representative electric motor control module can include a potted contactor module and a potted controller module at least partially nested inside the contactor module and mechanically connected to the contactor module. One or more connectors can be positioned between the contactor module and the controller module to electrically connect them together. In some embodiments, the potted contactor module comprises a carrier tray and a contactor assembled to the carrier tray. In some embodiments, the potted contactor module further comprises a contactor housing and an endcap assembled together with and containing the carrier tray and contactor. In some embodiments, the carrier tray includes one or more standoffs positioned to locate the controller module away from an end wall of the carrier tray to define a connector cavity containing the one or more connectors. In some embodiments, the controller module includes wireless communication capability.

In some embodiments, a representative method for assembling a motor control module can include assembling a contactor module, assembling a controller module, and electrically and mechanically connecting the contactor module and the controller module. In some embodiments, assembling the contactor module includes assembling a contactor into a contactor housing and pouring a first quantity of potting material into the contactor housing. In some embodiments, assembling the controller module includes assembling electrical components into a control housing and pouring a second quantity of potting material into the controller module. In some embodiments, the method further comprises positioning the controller module away from the contactor module creating a connector cavity configured to accommodate one or more connectors for electrically connecting the controller module and the contactor module. In some embodiments, the method further comprises at least partially nesting the controller module in the contactor module. In some embodiments, the method further comprises disconnecting the electrical and mechanical connections. In some embodiments, the controller module is a first controller module and the contactor module is a first contactor module, and further comprising replacing one of the first controller module and the first contactor module with a corresponding second controller module or a second contactor module.

The following examples provide additional embodiments of the present technology.

### Examples:

1. An electric motor control module, comprising:
   a potted contactor module;
   a potted controller module at least partially nested inside the contactor module and mechanically connected to the contactor module; and
   one or more connectors positioned between and electrically connecting the contactor module and the controller module.
2. The motor control module of example 1, wherein the potted contactor module comprises a carrier tray and a contactor carried by the carrier tray.
3. The motor control module of example 1 or 2, wherein the potted contactor module further comprises a contactor housing and an endcap containing the carrier tray and contactor.
4. The motor control module of any one of examples 1-3, wherein the carrier tray includes one or more standoffs positioned to locate the controller module away from an end wall of the carrier tray to define at least in part a connector cavity containing the one or more connectors.
5. The motor control module any one of examples 1-4, wherein the controller module includes wireless communication capability.
6. A winch, comprising:
   a frame;
   a cable drum;
   a drive motor carried by the frame and operatively connected to the cable drum; and
   a motor control module carried by the frame and electrically connected to the drive motor, the motor control module comprising:
      a potted contactor module;
      a potted controller module at least partially nested inside the contactor module and mechanically connected to the contactor module; and
      one or more connectors positioned between and electrically connecting the contactor module and the controller module.
7. The motor control module of example 6, wherein the potted contactor module comprises a carrier tray and a contactor carried by the carrier tray.
8. The motor control module of example 6 or 7, wherein the potted contactor module further comprises a contactor housing and an endcap containing the carrier tray and contactor.
9. The motor control module any one of examples 6-8, wherein the carrier tray includes one or more standoffs positioned to locate the controller module away from an end wall of the carrier tray to define a connector cavity containing the one or more connectors.
10. The motor control module any one of examples 6-9, wherein the controller module includes wireless communication capability.
11. A method for assembling a motor control module, the method comprising:
   assembling a contactor module, comprising:
      positioning a contactor in a contactor housing; and
      disposing a first quantity of potting material into the contactor housing;
   assembling a controller module, comprising:
      positioning electrical components into a control housing; and
      disposing a second quantity of potting material into the controller module; and
   electrically and mechanically connecting the contactor module and the controller module.
12. The method of example 11, further comprising positioning the controller module away from the contactor module creating a connector cavity positioned to accommodate one or more connectors for electrically connecting the controller module and the contactor module.
13. The method of example 11 or 12, further comprising at least partially nesting the controller module in the contactor module.
14. The method any one of examples 11-13, further comprising disconnecting the electrical and mechanical connections.
15. The method any one of examples 11-14, wherein the controller module is a first controller module and the contactor module is a first contactor module, and wherein the method further comprises replacing one of the first controller module or the first contactor module with a corresponding second controller module or a second contactor module.

When used in this specification and claims, the terms "comprises" and "comprising" and variations thereof mean that the specified features, steps or integers are included. The terms are not to be interpreted to exclude the presence of other features, steps or components.

The features listed or disclosed in the foregoing description, or the following claims, or the accompanying drawings, expressed in their specific forms or in terms of a means for performing the disclosed function, or a method or process for attaining the disclosed result, as appropriate, may, separately, or in any combination of such features, be utilised for realising the invention in diverse forms thereof.

## Claims

1. An electric motor control module, comprising:
a potted contactor module;
a potted controller module at least partially nested inside the contactor module and mechanically connected to the contactor module; and
one or more connectors positioned between and electrically connecting the contactor module and the controller module.

2. The motor control module of claim 1, wherein the potted contactor module comprises a carrier tray and a contactor carried by the carrier tray.

3. The motor control module of claim 2, wherein the potted contactor module further comprises a contactor housing and an endcap containing the carrier tray and contactor.

4. The motor control module of claim 2, wherein the carrier tray includes one or more standoffs positioned to locate the controller module away from an end wall of the carrier tray to define at least in part a connector cavity containing the one or more connectors.

5. The motor control module of claim 1, wherein the controller module includes wireless communication capability.

6. A winch, comprising:
a frame;
a cable drum;
a drive motor carried by the frame and operatively connected to the cable drum; and
a motor control module carried by the frame and electrically connected to the drive motor, the motor control module comprising:
a potted contactor module;
a potted controller module at least partially nested inside the contactor module and mechanically connected to the contactor module; and
one or more connectors positioned between and electrically connecting the contactor module and the controller module.

7. The motor control module of claim 6, wherein the potted contactor module comprises a carrier tray and a contactor carried by the carrier tray.

8. The motor control module of claim 7, wherein the potted contactor module further comprises a contactor housing and an endcap containing the carrier tray and contactor.

9. The motor control module of claim 7, wherein the carrier tray includes one or more standoffs positioned to locate the controller module away from an end wall of the carrier tray to define a connector cavity containing the one or more connectors.

10. The motor control module of claim 6, wherein the controller module includes wireless communication capability.

11. A method for assembling a motor control module, the method comprising:
assembling a contactor module, comprising:
positioning a contactor in a contactor housing; and
disposing a first quantity of potting material into the contactor housing;
assembling a controller module, comprising:
positioning electrical components into a control housing; and
disposing a second quantity of potting material into the controller module; and
electrically and mechanically connecting the contactor module and the controller module.

12. The method of claim 11, further comprising positioning the controller module away from the contactor module creating a connector cavity positioned to accommodate one or more connectors for electrically connecting the controller module and the contactor module.

13. The method of claim 11, further comprising at least partially nesting the controller module in the contactor module.

14. The method of claim 11, further comprising disconnecting the electrical and mechanical connections.

15. The method of claim 14, wherein the controller module is a first controller module and the contactor module is a first contactor module, and wherein the method further comprises replacing one of the first controller module or the first contactor module with a corresponding second controller module or a second contactor module.
